# EUROPÄISCHE PATENTANMELDUNG

(11) **EP 0 885 982 A1**
(43) Veröffentlichungstag der Anmeldung: **23.12.1998**
(21) Anmeldenummer: 97810384.4
(22) Anmeldetag: 18.06.1997
(51) Int. Cl.: C23C 14/32

(54) **Verfahren zum Beschichten eines Gegenstandes**

(71) Anmelder: FRAISA SA, 4512 Bellach (CH)
(72) Erfinder: Nägelin, Thomas, 4433 Ramlinsburg (CH); Maushart, Josef, 4573 Lohn (CH)
(74) Vertreter: Patentanwälte Breiter + Wiedmer AG

(57) **Zusammenfassung**

Bei einem Verfahren zum Beschichten der Oberfläche (16) eines Gegenstandes (10) aus Stahl mit einem Hartstoff (18) aus anorganischem Material wird das anorganische Material in einer Kammer unter Vakuum verdampft und auf der zu beschichtenden Oberfläche (16) als Hartstoff niedergeschlagen. Die Substrattemperatur (T_{S}) im Beschichtungsraum wird während des Beschichtungsvorganges auf einem Wert unterhalb von 200°C gehalten. Die Dicke (d) der auf der Oberfläche (16) niedergeschlagenen Hartstoffschicht (18) wird bevorzugt auf max. 0,5 µm eingestellt. Mit dem Verfahren lassen sich beschichtete Lehren aus niedrig legierten Stählen auf kostengünstige Weise herstellen.

## Beschreibung

Die Erfindung betrifft ein Verfahren zum Beschichten der Oberfläche eines Gegenstandes aus Stahl mit einem Hartstoff aus anorganischem Material, wobei das anorganische Material in einer Kammer unter Vakuum verdampft und auf der zu beschichtenden Oberfläche als Hartstoff niedergeschlagen wird. Im Rahmen der Erfindung liegt auch eine Verwendung von mit dem Verfahren beschichteten Gegenständen.

Zur Kontrolle der Massgenauigkeit von Bohrungen, Gewinden, Bolzen und anderen Teilen von Maschinen und Werkzeugen, deren Masse innerhalb von festgelegten Toleranzwerten liegen müssen, werden sogenannte Lehren, beispielsweise Lehrringe, Lehrzylinder oder Lehrgewinde, eingesetzt.

Lehren der genannten Art bestehen im einfachsten Fall aus gewöhnlichem niedrig legiertem Stahl mit einer präzis geschliffenen Prüf- oder Messfläche. Diese Lehren sind einfach und billig herzustellen. Da die Messfläche unbeschichtet ist, sind derartige Lehren aber wenig abriebfest und je nach Umgebungsbedingungen einer mehr oder weniger starken Korrosion ausgesetzt. Die Lebensdauer dieser einfachen Lehren aus gewöhnlichem Stahl ist demzufolge entsprechend kurz.

Es sind auch Lehren aus Stahl bekannt, deren Mess- bzw. Prüffläche mit einer Hartstoffbeschichtung aus beispielsweise TiN versehen ist. Zur Herstellung dieser Beschichtungen, die üblicherweise eine Dicke von 1 bis 2 µm aufweisen, wird Titan im Hochvakuum mittels einer Lichtbogenentladung verdampft. Durch Zudosieren von Stickstoff in die Reaktionskammer erfolgt unter den Betriebsbedingungen die Bildung von TiN, welches auf der Oberfläche der Lehre niedergeschlagen wird. Damit die Hartstoffbeschichtung eine gute Haftung auf der Oberfläche der Lehre aufweist, muss die Beschichtung bei Temperaturen zwischen etwa 500 und 600°C durchgeführt werden. Eine derart hohe Beschichtungstemperatur liegt über der Anlasstemperatur von beispielsweise niedrig legiertem Werkzeugstahl, diezwischen etwa 180 und 200°C liegt.

Zur Herstellung beschichteter Lehren müssen daher höher legierte Stähle eingesetzt werden, was sich in starkem Mass auf die Gestehungskosten einer Lehre auswirkt.

Der Erfindung liegt deshalb die Aufgabe zugrunde, ein Verfahren der eingangs genannten Art zu schaffen, mit dem auch ein niedrig legierter Stahl mit einer tiefen Anlasstemperatur beschichtet und als Lehre oder Messwerkzeug mit Prüfflächen eingesetzt werden kann.

Zur erfindungsgemässen Lösung der Aufgabe führt, dass die Substrattemperatur in der Kammer während des Beschichtungsvorganges auf einem Wert unterhalb von 200°C gehalten und die Dicke der auf der Oberfläche niedergeschlagenen Hartstoffschicht bevorzugt auf max. 1,0 µm, vorzugsweise auf max. 0,5 µm, eingestellt wird.

Durch die Herabsetzung der Beschichtungsdicke auf max. 0,5 µm gegenüber Schichtdicken von 1 bis 2 µm nach dem Stand der Technik kann die Beschichtungstemperatur soweit gesenkt werden, dass gewöhnliche niedrig legierte Stähle problemlos mit einer gut haftenden Hartstoffschicht versehen werden können.

Mit dem erfindungsgemässen Verfahren können somit billige Werkstoffe beschichtet werden, wodurch die Gestehungskosten beschichteter Lehren erheblich gesenkt werden. Ein wesentlicher Vorteil des erfindungsgemässen Verfahrens liegt auch darin, dass handelsübliche unbeschichtete Lehren aus niedrig legiertem Stahl direkt beschichtet werden können, da die Masstoleranz üblicher Lehren über der maximalen Schichtdicke von etwa 0,5 µm liegt.

Die erfindungsgemäss hergestellten Lehren zeigen eine gute Beständigkeit gegen abrasiven und adhäsiven Verschleiss. Wegen ihrer geringen Dicke sind die Schichten nicht spröde, so dass deren Haftfestigkeit auf der Unterlage trotz der verhältnismässig niedrigen Beschichtungstemperatur ausreichendist.

Beschädigungen an der Beschichtung und auch der gebrauchsbedingte Verschleiss sind visuell gut wahrnehmbar. Erfindungsgemäss beschichtete Lehren können daher durch Aufbringen einer neuen Beschichtung mehrmals aufbereitet werden.

Als Hartstoffschicht eignet sich in besonderem Masse Titannitrid. Grundsätzlich können jedoch alle verdampfbaren anorganischen Materialien eingesetzt werden, die nach dem Abscheiden aus der Gasphase die gewünschten Eigenschaften wie Verschleissfestigkeit und Korrosionsbeständigkeit aufweisen. Neben Titan können als anorganische Materialien beispielsweise Zirkon, Silizium, Aluminium und Magnesium oder eine Mischung bzw. Legierung dieser Materialien eingesetzt werden. Während des Beschichtungsvorgangs kann wenigstens ein reaktives Gas, vorzugsweise Stickstoff, Sauerstoff, Wasserstoff und/oder Acetylen, der Vakuumkammer in geringer Menge zugeführt werden, so dass sich mit den verdampften Metallen die entsprechenden Nitride, Oxide, Karbide oder Mischkomponenten bilden. Selbstverständlich können die Hartstoffe, sofern sie verdampfbar sind, auch ohne Reaktion in der Gasphase direkt verdampft und auf der Oberfläche des Gegenstandes niedergeschlagen werden.

Die Verdampfung des anorganischen Materials kann nach den allgemein bekannten Verfahren beispielsweise mittels elektrischer Bogenentladung, vorzugsweise über eine Lichtbogenentladung, erfolgen.

Zur Herstellung einer Beschichtung mit einer guten Haftfähigkeit hat es sich als vorteilhaft erwiesen, den zu beschichtenden Gegenstand auf eine Temperatur von etwa 80 bis 120°C vorzuwärmen. Im weiteren Verlauf des Beschichtungsverfahrens wird zweckmässigerweise darauf geachtet, dass die Substrattemperatur, d.h. die Temperatur im Beschichtungsraum, einen Wert von 160°C nicht wesentlich übersteigt. Eine kurzzeitige Erhöhung der Temperatur über die Anlasstemperatur des eingesetzten Stahls bewirkt noch kein Anlassen und kann daher toleriert werden.

Der mit dem erfindungsgemässen Verfahren zu beschichtende Gegenstand besteht bevorzugt aus einem Normalstahl, d.h. aus einem niedrig legierten Stahl, insbesondere aus einem Werkzeugstahl. Der Stahl weist eine tiefe Anlasstemperatur im Bereich von etwa 180 bis 300°C auf.

Der Anwendungsbereich der nach dem erfindungsgemässen Verfahren hergestellten beschichteten Gegenstände liegt vor allem im Bereich der Lehren wie Gewindelehren, Rundpassungslehren etc., Mess- oder Prüfflächen von Messwerkzeugen sowie Oberflächen oder Schneiden von Schneidwerkzeugen oder Implantaten aus der Medizinaltechnik.

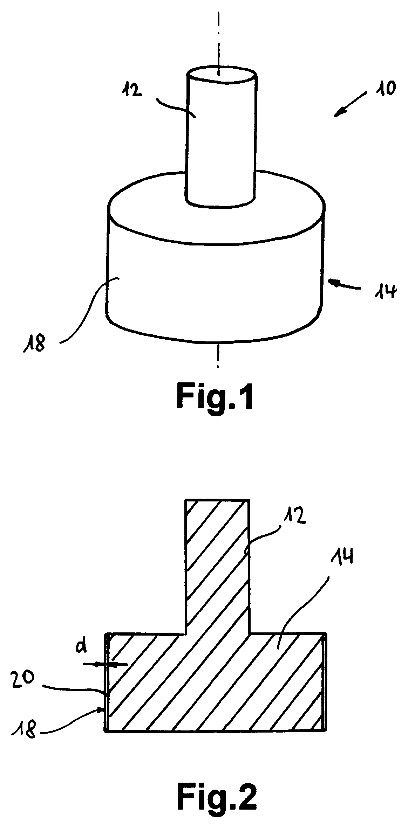

Weitere Vorteile, Merkmale und Einzelheiten der Erfindung ergeben sich aus der nachfolgenden Beschreibung eines bevorzugten Ausführungsbeispiels sowie anhand der Zeichnung; diese zeigt in
- - Fig. 1: eine Schrägsicht auf eine Lehre;
- - Fig. 2: einen Längsschnitt durch die Lehre von Fig. 1.

Eine Lehre 10 zur Prüfung der Massgenauigkeit einer in der Zeichnung nicht wiedergegebenen Bohrung besteht beispielsweise aus einem niedrig legierten Werkzeugstahl mit einer Anlasstemperatur T_{A} von z.B. 200°C. Die Lehre 10 weist einen Schaft 12 auf, der einends in den eigentlichen Lehrzylinder 14 übergeht, dessen Zylindermantelfläche 16 die Mess- bzw. Prüffläche dargestellt.

Zumindest die Zylindermantelfläche 16 ist mit einer Hartstoffschicht 18 aus beispielsweise Titannitrid versehen.

Zur Beschichtung von Lehren 10 mit TiN werden die Lehren auf eine Vorwärmtemperatur T_{V} von beispielsweise etwa 100°C vorgewärmt und in einer Vakuumkammer zur Beschichtung bereitgestellt. Die Beschichtung erfolgt durch Verdampfen von Titan über eine Lichtbogenentladung. Der Vakuumkammer wird Stickstoff in kleinen Mengen zugeführt, so dass sich in der Gasphase das gewünschte Titannitrid bildet, welches als Hartstoffschicht 18 auf den Zylindermantelflächen 16 sowie teilweise auch auf andern Oberflächenteilen der Lehren niedergeschlagen wird. Während des Beschichtungsvorganges wird darauf geachtet, dass die Substrattemperatur T_{S} in der Kammer nicht wesentlich über beispielsweise etwa 160°C steigt. Sobald die Dicke d der Hartstoffschicht einen Wert von beispielsweise 0,3 µm erreicht hat, wird der Beschichtungsvorgang beendet. Die beschichteten Lehren sind nach deren Entnahme aus der Vakuumkammer einsatzbereit.

## Patentansprüche

1. Verfahren zum Beschichten der Oberfläche (16) eines Gegenstandes (10) aus Stahl mit einem Hartstoff (18) aus anorganischem Material, wobei das anorganische Material in einer Kammer unter Vakuum verdampft und auf der zu beschichtenden Oberfläche (16) als Hartstoff niedergeschlagen wird,
dadurch gekennzeichnet, dass
die Substrattemperatur (T_{S}) in der Kammer während des Beschichtungsvorganges auf einem Wert unterhalb von 200°C gehalten wird.

2. Verfahren nach Anspruch 1, dadurch gekennzeichnet, dass die Dicke (d) der auf der Oberfläche (16) niedergeschlagenen Hartstoffschicht (18) auf max. 1,0 µm, vorzugsweise auf max. 0,5 µm, eingestellt wird.

3. Verfahren nach Anspruch 1 oder 2, dadurch gekennzeichnet, dass das anorganische Material aus Titan, Zirkon, Silizium, Aluminium, Magnesium oder einer Mischung bzw. Legierung dieser Materialien besteht.

4. Verfahren nach einem der Ansprüche 1 bis 3, dadurch gekennzeichnet, dass während des Beschichtungsvorganges wenigstens ein reaktives Gas, vorzugsweise Stickstoff, Sauerstoff, Wasserstoff und/oder Acetylen, der Vakuumkammer zugeführt wird.

5. Verfahren nach einem der Ansprüche 1 bis 4, dadurch gekennzeichnet, dass die Hartstoffschicht aus Titannitrid besteht.

6. Verfahren nach einem der Ansprüche 1 bis 5, dadurch gekennzeichnet, dass das anorganische Material mittels einer elektrischen Bogenentladung, vorzugsweise über eine Lichtbogenentladung, verdampft wird.

7. Verfahren nach einem der Ansprüche 1 bis 6, dadurch gekennzeichnet, dass der Gegenstand (10) auf eine Temperatur (Tᵥ) von etwa 80 bis 120°C vorgewärmt wird.

8. Verfahren nach einem der Ansprüche 1 bis 7, dadurch gekennzeichnet, dass die Substrattemperatur (T_{S}) auf einem Wert unterhalb von etwa 160°C gehalten wird.

9. Verfahren nach einem der Ansprüche 1 bis 8, dadurch gekennzeichnet, dass der zu beschichtende Gegenstand (10) aus einem niedrig legierten Stahl, insbesondere aus einem Werkzeugstahl, mit einer niedrigen Anlasstemperatur (T_{A}) im Bereich von etwa 180 bis 300°C besteht.

10. Anwendung des Verfahrens nach einem der Ansprüche 1 bis 9 zur Herstellung von beschichteten Lehren, wie Gewinde- und Rundpassungslehren, Mess- oder Prüfflächen von Messwerkzeugen sowie Oberflächen oder Schneiden von Schneidwerkzeugen oder Implataten aus der Medizinaltechnik.
